(19) Europäisches Patentamt

European Patent Office

Office européen des brevets

(11) EP 0 680 036 B1

(12) EUROPEAN PATENT SPECIFICATION

(45) Date of publication and mention
of the grant of the patent:
08.03.2000 Bulletin 2000/10

(51) Int Cl.⁷: **G11B 5/255**, G11B 5/41

(21) Application number: 95110702.8

(22) Date of filing: 14.12.1988

(54) **A process of treating slider bodies**

Verfahren zur Behandlung von Gleitkörpern

Procédé de traitement de corps glisseurs

(84) Designated Contracting States:
**DE FR GB**

(30) Priority: **10.03.1988  US 166215**

(43) Date of publication of application:
**02.11.1995  Bulletin 1995/44**

(62) Document number(s) of the earlier application(s) in
accordance with Art. 76 EPC:
**88311833.3 / 0 332 784**

(73) Proprietor: **SEAGATE TECHNOLOGY
INTERNATIONAL
Georgetown Grand Cayman Island (KY)**

(72) Inventors:
• **Brar, Amarjit Singh
  Edina, Minnesota 55435 (US)**
• **Sharma, Jagdish Preseb
  Bloomington, Minnesota 55438 (US)**

(74) Representative: **Kenyon, Sarah Elizabeth et al
Miller Sturt Kenyon
9 John Street
London WC1N 2ES (GB)**

(56) References cited:
**US-A- 3 778 308          US-A- 4 251 297
US-A- 4 419 404          US-A- 4 549 238**

• **PATENT ABSTRACTS OF JAPAN vol. 008 no.
  257 (P-316) ,24 November 1984 & JP-A-59 127214
  (SUWA SEIKOSHA KK) 23 July 1984,**
• **John L. Vossen, Werner Kern: "Thin Film
  Processes", Academic Press Inc., London, 1978,
  ISBN 0-12-7288250-5, p.42-45**

## Description

This invention relates to processes for treating slider bodies for magnetic reading and recording transducers.

The employment of selected surface coatings and other treatments is a well known technique for enhancing the useful life and reliability of magnetic media and sliders of magnetic data reading and recording transducers. Magnetic discs and sliders are subject to wear on their interfaces or areas of mutual surface engagement as they are moved relative to one another. Even in disc drives employing "flying" heads which normally are separated from the disc by a thin air foil, surface contact during repeated starts and stops of disc rotation can cause substantial wear, and eventually lead to a head crash.

Accordingly, surfaces of sliders and discs frequently are treated to increase their toughness and strength, and to reduce friction. US-A-4,251,297 discloses a boronised layer formed on the surface portion of a slider disposed to contact a magnetic recording medium. US-A-4,631,614 discloses a plasma process for improving saturation magnetisation of a transducer. In particular, a gap spacer material and a pole piece are deposited using an Alfesil target along with either argon or nitrogen gas.

In connection with a device in which the slider is normally in contact with a magnetic tape or disc, a technique to improve the slidability between the tape or disc and the slider is disclosed in US-A-4,649,488. The sliding surface of the slider is coated with zirconium oxide or other material having a high co-efficient of thermal expansion, in particular high enough to carbonise the binder of the recording medium.

US-A-4,619,861 discloses a plasma polymerisation technique for coating the particles which make up magnetic powders. The technique is said to improve the dispersability, squareness ratio and dusting of the magnetic powders.

Another known approach is to provide a passivation layer of sputtered carbon over the magnetic media or recording layer of a disc, both to protect the media layer against corrosion and to improve surface lubricity. An example of which can be found in EP-A-249 216. This carbon overcoat is quite thin, typically in the range of 300 to 400 Angstroms, and, as formed, includes micro-pores and sometimes "pinholes" exposing a recording layer. Another problem encountered with carbon overcoat is a build-up of debris, principally carbon particles, on the surface of the disc. The slider, due to high surface energy, tends to pick up this debris, leading ultimately to a head crash.

Patent Abstracts of Japan Vol. 12, Number 144 (p-697)[2991] 6, May 1988, discloses a magnetic recording medium comprising an underlying film layer, a non-magnetic metallic protective film, a carbon protective film and the top coat film on a non-magnetic substrate. The top coat film is formed of a plasma-polyerized film.

US-A-4,549,238 discloses a magnetic head slider consisting of aluminium oxide/titanium carbide. On its sliding side, adjacent a magnetic record carrier, a thin film is provided in which the titanium carbide has been removed by preferential reactive ion etching in a thin plasma.

The present invention seeks to provide a slider with an interfacing surface of improved toughness, hardness and lubricating characteristics, and reduced surface energy.

Furthermore, the present invention seeks to provide sliders having reduced friction at their interface, thereby to reduce noise due to friction and increase signal quality.

According to a first aspect of the present invention, there is provided a process for treating an exposed surface of a slider body formed of a ceramic material, including:

> enclosing within a plasma chamber a slider body which consists essentially of a ceramic material;
> generating and maintaining within said plasma chamber an inert gas plasma at a pressure substantially less than atmospheric pressure and for an amount of time selected substantially to etch an exposed surface of said slider body; and
> generating and maintaining within said chamber a plasma mixture including carbon tetrafluoride;

> characterised in that the plasma mixture consists essentially of the carbon tetrafluoride and an inert gas, with the carbon tetrafluoride comprising at least sixty percent by volume of the plasma mixture and the inert gas comprising at least 15 % by volume of the plasma mixture; and further characterised in that the step of generating and maintaining the plasma mixture is performed after said etching, at a selected pressure substantially less than atmospheric pressure and conducive to ion implantation, and at a selected temperature and for a selected time to enable at least fluorine ion implantation to at least a selected depth.

As a result of this treatment, a fluoropolymeric thin film is formed along the exposed surface of the slider. Ion implantation substantially increases the cohesive bonding strength of the ceramic material molecules through the film and deep into the substrate. Moreover, it is believed that extended chain polymers such as hexafluoroethane are formed along the slider surface to improve lubricity. Further fluoropolymers are believed to be formed, depending on the ceramic: e.g. calcium fluoride when sliders include calcium titanate or calcium oxide as a constituent, and titanium tetrafluoride for sliders composed at least partially of calcium titanate or titanium oxide. Lubricants formed in the case of nickel zinc and aluminium oxide sliders are believed to include nickel difluoride and aluminium trifluoride, respectively.

The fluorine ions react with the surface and form a carbon-fluorine film which reduces surface energy and therefore reduces debris pick-up by the slider. Fewer particles are generated due to the increased impact strength and better lubricity of the slider surfaces. Reduced friction also means reduced noise due to friction, for an enhanced data signal. Accordingly, employing the disclosed processes according to the present invention leads to reduced incidence of head crash for longer useful life of the data storage system, and further enhance signal quality.

The carbon tetrafluoride may comprise 75% to 85%, preferably 80%, of the mixture.

Said selected pressure may be in the range of from 27 Pa to 54 Pa (200 to 400 millitorr).

Said selected time may be approximately 25 to 30 minutes. In particular, where the slider is formed of calcium titanate or nickel zinc ferrite a selected time of approximately 25 minutes is preferred.

The cleaning or etching may be carried out at room temperature or about 100°C.

The selected temperature may be room temperature or about 100°C.

Other aspects of the invention are set out in the appended claims and include a slider subject to a process as claimed according to the first aspect of the present invention.

According to a second aspect of the present invention there is provided a slider for a magnetic data transducing head, said slider comprising: a slider body consisting essentially of a ceramic material and having a substantially flat interfacing surface, characterised in the implantation of fluorine ions in said slider body throughout a layer of said slider body including said interfacing surface.

Said selected layer preferably further is characterised by the formation of extended chain fluoropolymers, particularly along said interfacing surface.

The invention is illustrated, merely by way of example, in the accompanying drawings, in which:-

Figure 1 is a sectional view of part of a magnetic data storage disc provided with a known carbon overcoat;

Figure 2 is an enlarged partial view of Figure 1;

Figure 3 is a schematic representation of a plasma treatment apparatus for carrying out a process according to the present invention;

Figure 4 is a sectional view of the magnetic medium in Figure 1, after treatment by a process according to the present invention;

Figure 5 is an enlarged partial view of Figure 4;

Figure 6 is a perspective view of a ceramic slider; and

Figure 7 is an end view of the slider of Figure 6, following treatment by a process according to the present invention.

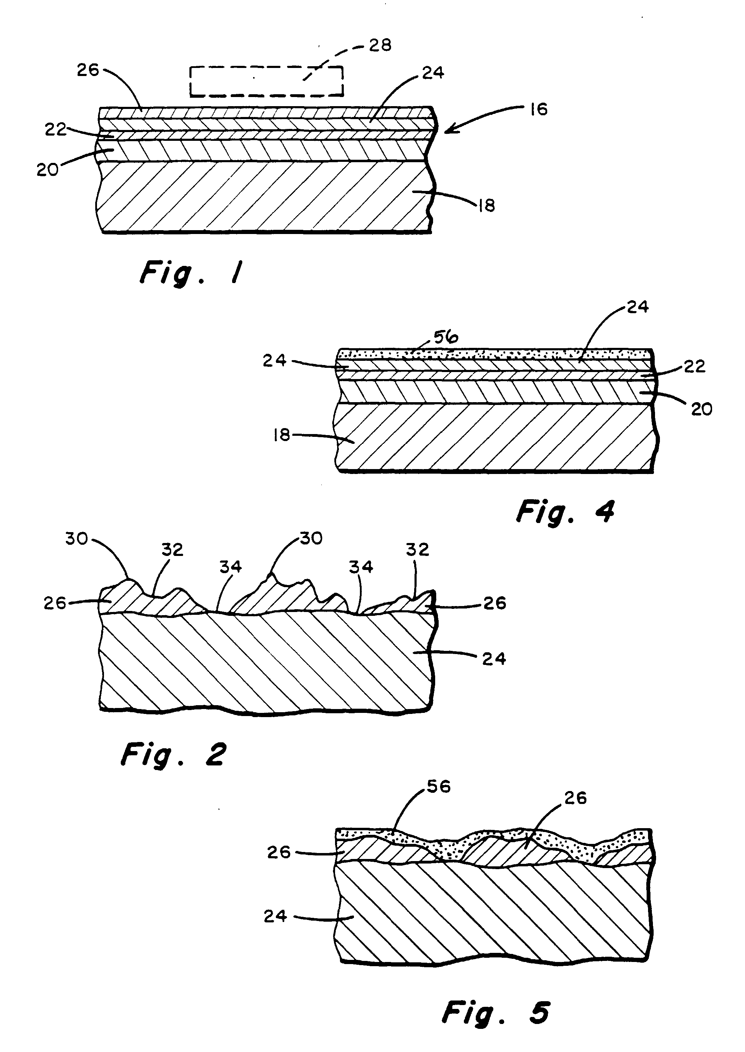

Turning now to the drawings, there is shown in Figure 1 a section of a magnetic data storage disc 16, formed by selectively layering a substrate 18 preferably formed of aluminium. A layer 20 consists of nickel, plated on the substrate 18 by an electroless process. The layer 20 has a high degree of surface roughness and therefore is polished to a thickness of approximately 0.01 mm ($10^5$ Angstrom - 400 micro-inch). Next, a layer 22 of chromium is deposited on the layer 20 by sputtering, to a thickness of about $10^{-6}$mm (10 Angstroms). A recording layer 24 then is sputtered onto the layer 22, to a thickness of about $2 \times 10^{-5}$ to $3 \times 10^{-5}$ mm (200 to 300 Angstroms). The recording layer 24 is formed on a magnetisable material, typically nickel/iron or nickel/cobalt alloy, which also may include chrome. In lieu of sputtering, the recording layer 24 in some cases may be formed by plating. Finally, a carbon layer 26 having a thickness of about $3 \times 10^{-5}$ to $4 \times 10^{-5}$ mm (300 to 400 Angstroms) is deposited onto the recording layer by sputtering.

The carbon layer 26 is provided to protect the recording layer against corrosion, and also to provide lubricity, thereby to reduce friction between the disc 16 and the slider 28 of a magnetic data transducing head. The slider 28 is shown in its normal operating position, supported approximately $2.5 \times 10^{-4}$ mm (10 micro-inch) above the disc by an air foil generated by disc rotation. Thus, whilst surface contact friction is not present during operation, repeated starting and stopping of the disc involves contact between the slider and disc, such that friction can damage the slider 28, the disc 16 or both.

In addition to providing corrosion protection and lubrication, the carbon layer 26 should be as smooth as possible to provide the desired narrow air foil or flying height. The utility of a data storage system employing the disc 16 and the slider 28 resides largely in the density of data storage. Generally, density increases as the gap between the slider 28 and the recording layer 24 is reduced. Therefore, it is advantageous to minimise the thickness of the carbon layer 26 as well as the flying height.

As seen from the enlarged view in Figure 2 showing only the layers 24, 26, the carbon layer 26 is not smooth but has numerous peaks 30, depressions or valleys 32, and pinholes 34 which leave the recording layer 24 exposed to damage, particularly due to moisture. Depositing a sufficient thickness of carbon to remove the pinholes 34 increases the thickness of the carbon layer 26 and therefore undesirably enlarges the gap between the slider and the recording layer 24. Of course, the flying height of the slider 28 must be sufficient to avoid peaks, and therefore the effective thickness of the carbon layer 26 is equal to the height of the peaks.

The surface roughness of the carbon layer 26 contributes to the friction between the disc and the slider. Furthermore, the carbon layer, particularly at peaks 30, is susceptible to fretting or fracturing from contact between the slider and the disc. The result is a build-up of debris consisting mainly of carbon particles, which are picked up by the slider. Build-up of such debris on the slider eventually leads to head crash.

To smooth and toughen the carbon layer 26 and to improve its lubricity, the disc 16 is treated with a plasma treating apparatus including a fluid tight plasma chamber 36 schematically illustrated in Figure 3 for carrying out a process according to the present invention. While just one disc 16 is shown in the chamber 36, it is to be understood that the chamber 36 can be of a sufficient size to accommodate many discs.

The apparatus includes an exhaust pump 38 in fluid communication with the chamber 36 for evacuating the chamber when desired. Also in fluid communication with the chamber, through lines 41 and 43 respectively, are first and second containers 40, 42. Containers 40, 42 respectively comprise a supply of an inert gas such as argon, and carbon tetrafluoride ($CF_4$) as a reactive gas. Other gases can be used as an inert gas, e.g. nitrogen or oxygen in lieu of the argon.

Valves 44, 46 control, respectively, the supply of argon and carbon tetrafluoride to the chamber. A power supply 48 biases an electrode 50 with respect to a grounded electrode 52 to generate an electric field necessary to ionise gas contained in the chamber 36.

To treat the disc 16, the exhaust pump 38 is actuated to substantially evacuate the chamber 36. After evacuation, the valve 44 is opened to supply argon to the chamber, with none of the reactive gas being supplied at this point. Argon is supplied to the chamber until pressure within the chamber is about 33 Pa (250 millitorr). Then, power at 600 watts is supplied to the electrode 50 to generate an electric field and ionise the argon, forming an argon plasma within the chamber 36. Etching/cleaning proceeds at a temperature of about 100°C commonly referred to as low temperature plasma.

The argon plasma is maintained in the chamber 36 for approximately 10 minutes, depending upon the load. The argon plasma cleans and etches the exposed surface of the carbon layer 26, particularly in removing or diminishing the peaks 30. This etching process, however, has the undesirable effect of increasing the surface energy of the carbon layer.

The disc 16 is then subject to a further plasma process. The chamber 36 again is evacuated, whereupon valves 44, 46 are opened to permit a mixture of argon and carbon tetrafluoride to enter the chamber. Valves 44, 46 are controlled in the comparative lengths of time for which they are opened, to provide a mixture which is at least 60% by volume, of carbon tetrafluoride. Preferably the percentage of carbon tetrafluoride is in the range of 75% to 85% by volume, with a particularly preferred mixture being 80% carbon tetrafluoride and 20% argon. The argon and carbon tetrafluoride are permitted to enter the chamber 36 until the pressure within the chamber is in the range of from 27 Pa to 54 Pa (200 to 400 millitorr), and preferably about 47 Pa (350 millitorr).

In general, higher pressure enhances ion penetration, while lower pressure improves plasma flow. Power at 600 watts is supplied to the electrode 50 and the plasma process proceeds at approximately 100°C. The preferred exposure time has been found to be 25 to 30 minutes, depending upon the area of the disc and materials.

During this treatment, conditions inside the chamber 36 become increasingly favourable for reactions of the fluorine ions with carbon, thus to form extended chain fluoropolymers along and beneath exposed surfaces of the carbon layer 26. In particular, one or more of the following reactions is believed to occur:

$$6CF_4 + 2C \rightarrow 4C_2F_6$$

$$CF_4 + C \rightarrow C_2F_4$$

$$2CF_4 + 4C \rightarrow 2C_3F_4$$

Thus, one or more of the above fluoropolymers, namely hexafluoroethane, tetrafluoroethylene and tetrafluoropropylene are believed to be formed over the surface of the carbon layer, and into the carbon layer to a depth which increases with the time of exposure in the plasma chamber. In effect, at least a portion of the carbon layer is fluorinated, with that portion of the carbon layer being altered to a thin film of carbon and extended chain fluoropolymers.

Oxygen or nitrogen can be supplied to the chamber 26 in lieu of argon, resulting in the formation of further fluoropolymers, it is believed, in accordance with the following reactions:

$$2CF_4 + O_2 \rightarrow 2CF_4O$$

$$5CF_4 + 2N_2 \rightarrow 4CF5N + C$$

Thus, the addition of oxygen, preferably at 20% to 30% of the plasma mixture by volume, is believed to form tetrafluoromethylaldehyde alone the exposed surfaces of the carbon layer 26. Similarly, the provision of nitrogen at about 20% to 30% of the mixture results in formation of pentafluoroaminomethane.

Due to the superior bonding strength of the extended chain fluoropolymers, the fluorinated carbon film has a greater surface fatigue and fretting strength than the untreated carbon layer. Further, the fluorinated carbon film reduces slider/disc friction due to improved lubricity, as these polymers act as solid lubricants.

In addition to their part in forming extended chain fluoropolymers, carbon and fluorine ions generated during the plasma process become implanted in the carbon layer, particularly in micro-pores, defects, valleys 32 and pinholes 34, thus filling in the pinholes to provide positive protection against moisture penetration. In combination with the etching action of the argon in removing or reducing the peaks 30, this ion implanting thus tends to smooth the surface of the carbon layer 26. Yet another benefit of the combined ion implantation and reaction product is a lower surface energy of the carbon layer 26, thus reducing the chance of surface contamination, enhancing surface lubricity and preventing corrosion.

A segment of the disc 16 after treatment is shown in Figure 4, and in greater detail in Figure 5. While much of the carbon layer 26 remains in its original form, a fluorinated carbon film 56 has formed which consists of carbon and the above mentioned extended chain fluoropolymers. Asperities or peaks in the original carbon layer have been reduced or removed by the argon etching, while the micro-pores, defects, valleys and pinholes have been at least partially filled by the implantation of ions. Consequently, the carbon layer 26 as treated is substantially smoother than the original carbon layer. The overall surface energy is reduced, as the ion implantation and the reaction product film on the surface reduces surface energy and overcomes the tendency of argon etching to increase the surface energy. The increasing smoothness of course further reduces friction. The accompanying reduction of noise due to friction enhances the signal generated in the transducing head, in particular, the signal to noise ratio. Due to the nature of the bonding of the fluoropolymers, the elasticity and damping characteristics of the surface are also improved.

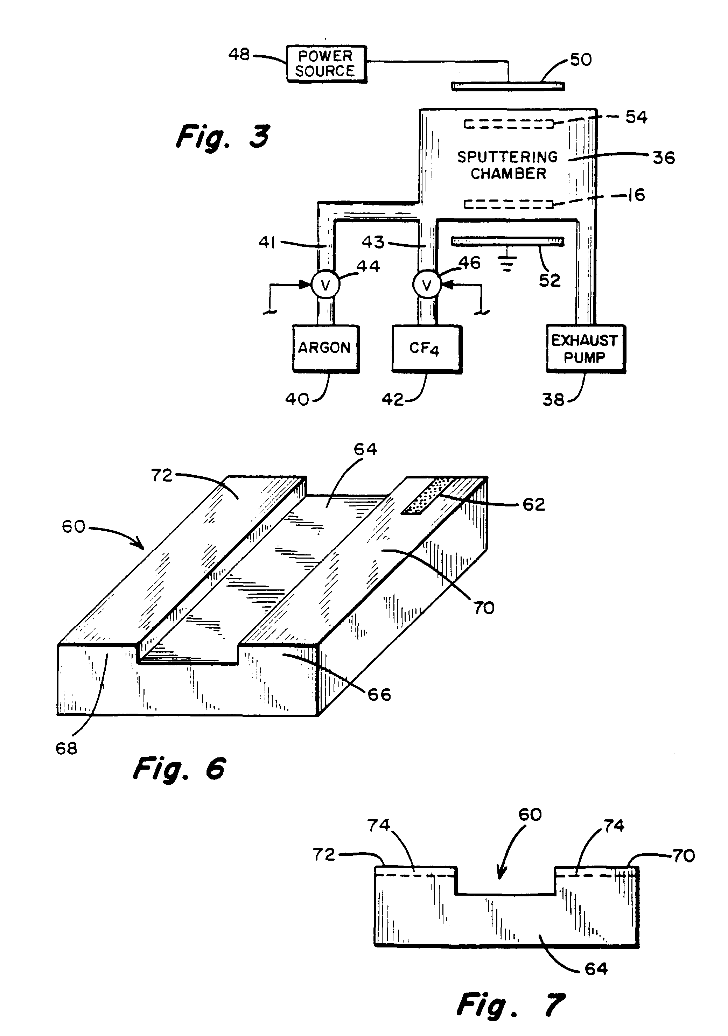

Figure 6 shows a transducing head including a slider 60 and a ferrite core 62 glass bonded on the slider. The slider 60 is of the catamaran type, including a main body 64 and two parallel skis 66, 68. Top surfaces 70, 72 of the skis 66, 68 respectively together comprise an interfacing surface of the slider 60 which contacts the disc 16 during the starting and stopping of disc rotation. The slider 60 is constructed of a ceramic material such as calcium titanate, NiZn ferrite, barium titanate, MnZn ferrite and Alsimag ($Al_2O_3$+TiC).

The surface characteristics of the slider 60, particularly along the surfaces 70, 72, can be enhanced by treating the slider 60 in processes similar to those described in connection with the disc 16. In particular, the slider 60 or a plurality of similar sliders can be contained in the chamber 36 in an argon plasma environment similar to that previously described, except that the time preferred is 15 to 25 minutes.

In the fluorinating process, argon remains the preferred inert gas.

The process described above in connection with the disc 16 can be employed to improve the surface properties of the slider 60. More particularly, one or more sliders can be placed in the chamber 36 for argon plasma etching, followed by treatment with the plasma gas mixture of argon and carbon tetrafluoride. Again, the carbon tetrafluoride should comprise at least 60% by volume of the plasma mixture, with the preferred range being 75% to 85%, 80% being the highly preferred amount. The etching and fluorinating treatment processes both take place at about 100°C. Alternatively, the etching treatment process may be carried out at room temperature and the fluorinating treatment process carried out at about 100°C. The pressure during fluorinating again is 27 Pa to 54 Pa (200 to 400 millitorr), preferably 47 Pa (350 millitorr).

While the treatment of magnetic media and magnetic head sliders is similar, the desired results in each case occur for different reasons. In particular, formation of extended chain fluoropolymers on the carbon layer of the disc 16, improves lubricity, and is a primary benefit of the plasma treatment for magnetic media. With sliders, in contrast, the primary benefit of the treatment appears to be the reduced surface energy and increased surface toughness, both of which occur as a result of combined ion implantation and reach in product formation. Consequently, the optimum fluorinating treatment time for sliders is largely a function of the desired depth of ion penetration. Penetration depth has been found to be about $2.5 \times 10^{-5}$ mm (25 Angstroms) with an exposure time of 45 minutes.

Further, however, it has been found, for example in the case of calcium titanate sliders and nickel zinc ferrite sliders, that the optimum exposure time is about 25 minutes. With increased exposure beyond 25 minutes, the argon etching effect appears detrimentally to offset the benefits of deposition of a fluorinated layer.

By lowering surface energy, due to the combined effect of ion penetration and reaction product film on the surface, the amount of debris picked up by the slider during normal operation is considerably reduced. This treatment improves the cohesive bonding of the slider ceramic material as well, thus increasing the slider surface toughness and reducing friction. All these factors contribute to longer life of data recording systems.

Formation of extended chain fluoropolymers is believed to be present, though not as important a factor as in the case of magnetic media. For example, in the case of a calcium titanate slider, the following reaction is believed to occur:

$$CaTiO_2 + CF_4 \rightarrow CaF_2 + TiF_2 + CO_2$$

Thus, as indicated in Figure 7, the plasma treatment forms a fluorinated layer 74 at the surface of the slider 60, particularly at surfaces 70, 72, characterised by ion implantation and formation of extended chain fluoropolymers. The fluoropolymers enhance the lubricity of the slider 60. In particular, when a treated slider and a treated disc are used in combination, the friction at low load is reduced by 33% to 40%.

The plasma cleaning and fluorinating treatments, when applied to sliders, substantially enhance the useful life and performance of magnetic data reading and recording devices. The respective treatment surfaces show greater strength and toughness, along with lower surface energy and thus a reduced affinity for pick-up of debris. Surface lubricity is enhanced by the extended chain fluoropolymers which provide a solid lubricant, although the primary improvement in slider surface properties arises from ion penetration.

## Claims

1. A process for treating an exposed surface of a slider body formed of a ceramic material, including:

enclosing within a plasma chamber (36) a slider body (64) which consists essentially of a ceramic material;
generating and maintaining within said plasma chamber an inert gas plasma at a pressure substantially less than atmospheric pressure and for an amount of time selected substantially to etch an exposed surface of said slider body; and
generating and maintaining within said chamber a plasma mixture including carbon tetrafluoride;

characterised in that the plasma mixture consists essentially of the carbon tetrafluoride and an inert gas, with the carbon tetrafluoride comprising at least sixty percent by volume of the plasma mixture and the inert gas comprising at least 15% by volume of the plasma mixture; and further characterised in that the step of generating and maintaining the plasma mixture is performed after said etching, at a selected pressure substantially less than atmospheric pressure and conducive to ion implantation, and at a selected temperature and for a selected time to enable at least fluorine ion implantation to at least a selected depth.

2. A process as claimed in claim 1, characterised in that said inert gas is argon.

3. A process as claimed in any preceding claims, characterised in that the carbon tetrafluoride comprises from 75% to 85% of said mixture.

4. A process as claimed in any preceding claims, characterised in that the carbon tetrafluoride comprises 80% of said mixture.

5. A process as claimed in any preceding claims, characterised in that said selected pressure is in the range of from 27 Pa to 54 Pa (200 to 400 millitorr).

6. A process as claimed in any preceding claims, characterised in that said selected time is approximately 25 to 30 minutes.

7. A process as claimed in any preceding claims, characterised in that said slider is formed of calcium titanate or nickel zinc ferrite and that said selected time is approximately 25 minutes.

8. A process as claimed in any preceding claims, characterised in that the cleaning or etching is carried out at room temperature.

9. A process as claimed in any of claims 1 to 7, characterised in that the cleaning or etching is carried out at about 100°C.

10. A process as claimed in any preceding claims, characterised in that the selected temperature is room temperature .

11. A process as claimed in any of claims 1 to 9, characterised in that the selected temperature is about out 100°C.

12. A slider for a magnetic data transducing head, said slider comprising: a slider body (64) consisting essentially of a ceramic material and having a substantially flat interfacing surface (70, 72), characterised in the implantation of fluorine ions in said slider body throughout a layer of said slider body including said interfacing surface.

13. A slider as claimed in claim 12 characterised in that said selected layer further is characterised by the formation of extended chain fluoropolymers, particularly along said interfacing surface.

## Patentansprüche

1. , Verfahren zur Behandlung einer freiliegenden Oberfläche eines Gleiterkörpers, der aus einem keramischen Material gebildet ist, wobei das Verfahren die folgenden Schritte einschließt:

Einschließen eines Gleiterkörpers (64), der im wesentlichen aus einem Keramikmaterial besteht, im Inneren einer Plasmakammer (36),

Erzeugen und Aufrechterhalten eines inerten Gasplasmas in der Plasmakammer bei einem Druck, der wesentlich kleiner als der atmosphärische Druck ist, und über eine Zeitdauer, die im wesentlichen so ausgewählt ist, daß eine freiliegende Oberfläche des Gleiterkörpers geätzt wird, und

Erzeugen und Aufrechterhalten einer Plasmamischung, die Tetrafluorkohlenstoff einschließt, in der Kammer,

dadurch gekennzeichnet, daß die Plasmamischung im wesentlichen aus dem Tetrafluorkohlenstoff und einem inerten Gas besteht, wobei der Tetrafluorkohlenstoff zumindest 60 Volumenprozente der Plasmamischung bildet, und das inerte Gas zumindest 15 Volumenprozente der Plasmamischung bildet, und weiterhin dadurch gekennzeichnet, daß der Schritt der Erzeugung und Aufrechterhaltung der Plasmamischung nach dem Ätzen bei einem ausgewählten Druck, der im wesentlichen kleiner als der atmosphärische Druck ist und zu einer Ionenimplantation führt, und bei einer ausgewählten Temperatur und über eine ausgewählte Zeit durchgeführt wird, um zumindest eine Fluor-Ionenimplantation bis zu zumindest einer ausgewählten Tiefe zu ermöglichen.

2. Verfahren nach Anspruch 1, dadurch gekennzeichnet, daß das inerte Gas Argon ist.

3. Verfahren nach einem der vorhergehenden Ansprüche, dadurch gekennzeichnet, daß der Tetrafluorkohlenstoff von 75% bis 85% der Mischung bildet.

4. Verfahren nach einem der vorhergehenden Ansprüche, dadurch gekennzeichnet, daß der Tetrafluorkohlenstoff 80% der Mischung bildet.

5. Verfahren nach einem der vorhergehenden Ansprüche, dadurch gekennzeichnet, daß der ausgewählte Druck im Bereich von 27 Pa bis 54 Pa (200-400 Millitorr) liegt.

6. Verfahren nach einem der vorhergehenden Ansprüche, dadurch gekennzeichnet, daß die ausgewählte Zeit ungefähr 25-30 Minuten beträgt.

7. Verfahren nach einem der vorhergehenden Ansprüche, dadurch gekennzeichnet, daß der Gleiter aus Calciumtitanat oder Nickelzinkferrit gebildet ist, und daß die ausgewählte Zeit ungefähr 25 Minuten beträgt.

8. Verfahren nach einem der vorhergehenden Ansprüche, dadurch gekennzeichnet, daß das Reinigen oder Ätzen bei Raumtemperatur ausgeführt wird.

9. Verfahren nach einem der Ansprüche 1-7, dadurch gekennzeichnet, daß die Reinigung oder das Ätzen bei ungefähr 100°C ausgeführt wird.

10. Verfahren nach einem der vorhergehenden Ansprüche, dadurch gekennzeichnet, daß die ausgewählte Temperatur Raumtemperatur ist.

11. Verfahren nach einem der Ansprüche 1-9, dadurch gekennzeichnet, daß die ausgewählte Temperatur ungefähr 100°C beträgt.

12. Gleiter für einen magnetischen Datenwandlerkopf, der folgendes umfaßt: einen Gleiterkörper (64), der im wesentlichen aus einem keramischen Material besteht und eine im wesentlichen ebene Grenzfläche (70, 72) aufweist, gekennzeichnet durch die Implantation von Fluorionen in den Gleiterkörper über die Gesamtheit einer Schicht des Gleiterkörpers unter Einschluß der Grenzfläche.

13. Gleiter nach Anspruch 12, dadurch gekennzeichnet, daß die ausgewählte Schicht weiterhin durch die Bildung von langkettigen Fluorpolymeren, insbesondere entlang der Grenzfläche, gekennzeichnet ist.

## Revendications

1. Procédé de traitement d'une surface exposée d'une pièce de coulissement formée d'un matériau céramique, qui comprend :

la mise en place, dans une chambre à plasma (36), d'une pièce de coulissement (64) qui est constituée essentiellement d'un matériau céramique ;
la production et le maintien, dans ladite chambre à plasma, d'un plasma d'un gaz inerte sous une pression sensiblement inférieure à la pression atmosphérique, et pendant un laps de temps sélectionné sensiblement de façon à graver une surface exposée de ladite pièce de coulissement ; et
la production et le maintien, dans ladite chambre, d'un mélange de plasma qui comprend du tétrafluorure de carbone ;

caractérisé en ce que le mélange de plasma est constitué essentiellement de tétrafluorure de carbone et d'un gaz inerte, le tétrafluorure de carbone représentant au moins 60 % en volume du mélange de plasma et le gaz inerte représentant au moins 15 % en volume du mélange de plasma ; et caractérisé en outre en ce que l'étape de production et de maintien du mélange de plasma est réalisée après ladite gravure, sous une pression sélectionnée sensiblement inférieure à la pression atmosphérique et conduisant à une implantation d'ions, et à une température sélectionnée et pendant un laps de temps sélectionné pour permettre au moins l'implantation d'ions fluor jusqu'à au moins une profondeur sélectionnée.

2. Procédé selon la revendication 1, caractérisé en ce que ledit gaz inerte est l'argon.

3.  Procédé selon l'une quelconque des revendications précédentes, caractérisé en ce que le tétrafluorure de carbone représente de 75 à 85 % dudit mélange.

4.  Procédé selon l'une quelconque des revendications précédentes, caractérisé en ce que le tétrafluorure de carbone représente 80 % dudit mélange.

5.  Procédé selon l'une quelconque des revendications précédentes, caractérisé en ce que ladite pression sélectionnée est comprise entre 27 et 54 Pa (entre 200 et 400 millitorrs).

6.  Procédé selon l'une quelconque des revendications précédentes, caractérisé en ce que ledit laps de temps sélectionné est d'approximativement 25 à 30 minutes.

7.  Procédé selon l'une quelconque des revendications précédentes, caractérisé en ce que ladite pièce de coulissement est formée de titanate de calcium ou de ferrite de nickel et de zinc, et que ledit laps de temps sélectionné est d'environ 25 minutes.

8.  Procédé selon l'une quelconque des revendications précédentes, caractérisé en ce que le nettoyage ou la gravure est effectué à la température ambiante.

9.  Procédé selon l'une quelconque des revendications 1 à 7, caractérisé en ce que le nettoyage ou la gravure est effectué à environ 100°C.

10. Procédé selon l'une quelconque des revendications précédentes, caractérisé en ce que la température sélectionnée est la température ambiante.

11. Procédé selon l'une quelconque des revendications 1 à 9, caractérisé en ce que la température sélectionnée est d'environ 100°C.

12. Coulisseau pour une tête de transduction de données magnétiques, ledit coulisseau comprenant : une pièce de coulissement (64) constituée essentiellement d'un matériau céramique et ayant une surface d'interface (70, 72) sensiblement plane, caractérisée par l'implantation d'ions fluorure dans ladite pièce de coulissement à travers une couche de ladite pièce de coulissement comprenant ladite surface d'interface.

13. Coulisseau selon la revendication 12, caractérisé en ce que ladite couche sélectionnée est en outre caractérisée par la formation de fluoropolymères à chaîne étendue, en particulier le long de ladite surface d'interface.

**Fig. 1**

**Fig. 4**

**Fig. 2**

**Fig. 5**

**Fig. 3**

48 — POWER SOURCE

50

54

SPUTTERING CHAMBER — 36

16

41

43

44 V

46 V

52

40 ARGON

42 CF₄

38 EXHAUST PUMP

**Fig. 6**

64

72

60

62

70

66

68

**Fig. 7**

60

74

74

72

70

64